# EUROPÄISCHE PATENTANMELDUNG

(11) **EP 2 701 473 A2**
(43) Veröffentlichungstag der Anmeldung: **26.02.2014**
(21) Anmeldenummer: 13181035.0
(22) Anmeldetag: 20.08.2013
(51) Int. Cl.: H05K 1/11, F21V 29/00, H05K 1/02, H05K 1/18, H05K 3/02

(54) **LED-Flächenstrahler**

(30) Priorität: 22.08.2012 DE 102012214887
(71) Anmelder: RIDI Leuchten GmbH, 72417 Jungingen (DE)
(72) Erfinder: Pannewitz, Manfred, 72419 Neufra (DE)
(74) Vertreter: BRP Renaud & Partner

(57) **Zusammenfassung**

Die Erfindung betrifft einen LED-Flächenstrahler (1),
- mit einer Mehrzahl von LED-Leuchtmitteln (5),
- mit einer Platine (2), deren elektrisch leitende Oberfläche mittels linienartiger Abtrennungen (3) in eine Mehrzahl von flächig ausgebildeten Leiterbahn-Segmenten (4) unterteilt ist, derart, dass sie aneinander angrenzend und elektrisch voneinander getrennt angeordnet sind,
- wobei wenigstens ein erstes Leiterbahn-Segment (4) und ein an das erste Leiterbahn-Segment (4) angrenzendes zweites Leiterbahn-Segment (4) mittels eines LED-Leuchtmittels (5) elektrisch miteinander verbunden sind.

## Beschreibung

Die vorliegende Erfindung betrifft einen LED-Flächenstrahler.

LED-Flächenstrahler kommen zum Einsatz, wenn zur Beleuchtung eines Raumes oder ähnlichem eine Lichtquelle benötigt wird, die sich durch einen geringen Energieverbrauch auszeichnet, sich dennoch zur großflächigen Abstrahlung von Licht eignet.

Für den Fall, dass in einem solchen LED-Flächenstrahler eine besonders große Anzahl von einzelnen LED-Elementen verwendet werden soll, um mittels diesen großflächig Licht abzustrahlen, können diese LED-Elemente auf einer Platine befestigt werden, wobei auf einer solchen Platine dann üblicherweise geeignete Leiterbahnen vorgesehen sind, mittels welcher die LED-Elemente elektrisch mit der Platine kontaktiert werden können, so dass die auf der Platine angeordneten LED-Elemente elektrisch mit einer elektrischen Energiequelle verbunden werden können.

Derartige LED-Flächenstrahler weisen jedoch den Nachteil auf, dass sich die LED-Elemente - insbesondere bei einer großen Anzahl von auf der Platine angeordneten LED-Elementen - aufgrund dissipativer Effekte und damit verbundener Wärmeentwicklung - in den LED-Elementen relativ schnell und stark auf unerwünschte Weise erhitzen kann, da die auf diese Weise erzeugte Abwärme von der Platine nur unzureichend abgeführt werden kann.

Es ist daher eine Aufgabe der vorliegenden Erfindung, eine verbesserte Ausführungsform für einen LED-Flächenstrahler anzugeben, bei welcher oben genannte Nachteile beseitigt oder zumindest reduziert sind.

Die oben genannte Aufgabe wird gelöst durch den LED-Flächenstrahler gemäß dem unabhängigen Anspruch 1. Bevorzugte Ausführungsformen sind Gegenstand der abhängigen Ansprüche.

Die Erfindung beruht auf dem allgemeinen Gedanken, für einen LED-Flächenstrahler eine Platine zu verwenden, die flächig ausgebildete Leiterbahn-Segmente bereitstellt, welche mittels linienartiger Abtrennungen elektrisch voneinander getrennt sind. Unter dem Begriff "linienartig" ist dabei generell zu verstehen, dass die Breite der linienartigen Abtrennungen - also entlang einer Richtung quer zur Erstreckungsrichtung der linienartigen Abtrennungen - zwischen den Leiterbahn-Segmenten wesentlich kleiner ist als eine Breite der flächigen Leiterbahn-Segmente selbst.

Die elektrische Verbindung zwischen solchen, flächigen Leiterbahn-Segmenten wird mittels der LED-Leuchtmittel realisiert. Unter dem Begriff LED-Leuchtmittel ist grundsätzlich ein licht-emittierendes halbleiterbasiertes Bauelement in der Art einer Leuchtdiode (LED) zu verstehen, welche in einer weiterbildenden Ausführungsform aber auch in der Art eines LED-Chips ausgebildet sein kann. Das LED-Leuchtmittel kann im einfachsten Fall also eine herkömmliche LED mit zwei elektrischen Anschlüssen (Anode und Kathode) sein.
Die Ansteuerung und Versorgung der LED-Leuchtmittel mit elektrischer Energie kann mittels eines externen Steuergeräts erfolgen.

Durch die Verwendung von flächig ausgebildeten metallischen Leiterbahn-Segmenten, welche nur durch dünne, linienartige Abtrennungen voneinander getrennt sind, lässt sich von den LED-Leuchtmitteln erzeugte Abwärme auf einfache und besonders effektive Weise abführen, da die flächig ausgebildeten Leiterbahn-Segmente eine große Grenzfläche mit einer Umgebung der Platine ausbilden, so dass auch große Wärmemengen schnell und effektiv von der Platine in die Umgebung abgeführt werden können. Auf diese Weise wird eine unerwünschte Überhitzung der LED-Leuchtmittel, insbesondere wenn eine große Anzahl an LED-Leuchtmitteln in dem erfindungsgemäßen LED-Flächenstrahler zum Einsatz kommen soll, vermieden.

Der erfindungsgemäße LED-Flächenstrahler umfasst eine Mehrzahl von LED-Leuchtmittel sowie eine Platine, deren elektrisch leitende Oberflächen mittels linienartiger Abtrennungen in eine Mehrzahl von flächig ausgebildeten Leiterbahn-Segmenten unterteilt ist. Die Unterteilung erfolgt dabei derart, dass die Leiterbahn-Segmente aneinander angrenzen und elektrisch voneinander getrennt angeordnet sind. Erfindungsgemäß sind wenigstens ein erstes Leiterbahn-Segment und ein an das erste Leiterbahn-Segment angrenzendes zweites Leiterbahn-Segment mittels eines LED-Leuchtmittels elektrisch miteinander verbunden.

In einer technisch besonders einfach herzustellenden und somit kostengünstigen Ausführungsform kann die Platine des LED-Flächenstrahlers eine Substratschicht umfassen, wobei die Mehrzahl von Leiterbahn-Segmenten gemäß dieser Ausführungsform aus einer auf der Substratschicht angeordneten Metallschicht gebildet ist. Die linienartige Abtrennung zweier aneinander angrenzender Leiterbahn-Segmente ist dabei jeweils mittels einer Materialaussparung der Metallschicht zwischen diesen beiden Leiterbahn-Segmenten realisiert.

Um sicherzustellen, dass ein möglichst großer Oberflächenbereich der Platine zur Wärmeabführung verwendet werden kann, kann die Materialaussparung zwischen zwei benachbarten Leiterbahn-Segmenten in der Art eines Aussparungskanals mit einer vorbestimmten Aussparungskanal-Breite ausgebildet sein. Zum Zwecke einer möglichst homogenen und gleichmäßigen Abstrahlung von Licht durch die auf der Platine angeordneten LED-Leuchtmittel kann wenigstens ein Leiterbahn-Segment wenigstens abschnittsweise rechteckartig ausgebildet sein, wobei dann eine Breite des abschnittsweise rechteckartig ausgebildeten Leiterbahn-Segments wenigstens ein Zehnfaches, vorzugsweise wenigstens ein Zwanzigfaches, und höchst vorzugsweise wenigstens ein Fünfzigfaches einer Breite der Aussparungskanal-Breite beträgt.

Eine besonders effektive Abführung der von den LED-Leuchtmitteln erzeugten Abwärme von der Platine lässt sich erzielen, wenn die Breite (B) des abschnittsweise rechteckartig ausgebildeten Leiterbahn-Segments zwischen 8mm und 13mm, vorzugsweise zwischen 9mm und 12mm, höchst vorzugsweise zwischen 10 mm und 11 mm, beträgt.

Um den auf der Platine zur Verfügung stehenden Bauraum besonders effektiv zur Abführung von Abwärme zu nutzen, sollte die vom Aussparungskanal in Anspruch genommene Fläche möglichst gering sein. Dies kann durch eine Ausbildung der Aussparungskanäle mit möglichst kleiner Aussparungskanal-Breite erreicht werden, ohne dass die elektrische Isolierung zwischen benachbarten Leiterbahn-Segmenten gefährdet wird. Besonders gute Ergebnisse werden diesbezüglich erzielt, wenn die Aussparungskanal-Breite zwischen 0,2mm und 0,5mm vorzugsweise zwischen 0,3mm und 0,4mm, beträgt.

Als fertigungstechnisch besonders günstig erweist sich eine Ausführungsform, bei welcher eine Dicke der Platine zwischen 1,4mm und 1,6mm, vorzugsweise 1,5mm, beträgt, und/oder eine Dicke der Metallschicht zwischen 30µm und 40µm, vorzugsweise 35 µm, beträgt.

In einer weiterbildenden Ausführungsform kann die Materialaussparung durch einen Ätzprozess hergestellt sein. Auf diese Weise lässt sich der erfindungsgemäße LED-Flächenstrahler mittels eines industriellen Herstellungsprozesses in großen Stückzahlen hergestellt, sodass die Herstellungskosten des erfindungsgemäßen LED-Flächenstrahlers signifikant reduziert werden können.

In einer besonders bevorzugten Ausführungsform, welche einen besonders widerstandsarmen elektrischen Stromfluss durch die Leiterbahn-Segmente ermöglicht, ist die Metallschicht eine Kupferschicht. Durch die Verwendung einer solchen Kupferschicht lässt sich die beim elektrischen Stromfluss durch die Leiterbahn-Segmente erzeugte Abwärme stark reduzieren.

Vorzugsweise ist das wenigstens eine LED-Leuchtmittel auf der Metallschicht befestigt. Dies bedeutet, dass das wenigstens eine LED-Leuchtmittel auf einfache Weise auf der die Leiterbahn-Segmente ausbildenden Metallschicht angebracht werden kann. In einer dazu alternativen Ausführungsform kann das wenigstens eine LED-Leuchtmittel auf einer von der Metallschicht abgewandten Rückseite der Substratschicht befestigt sein und mittels zweier elektrischer Durchführungen mit dem ersten und zweiten Leiterbahn-Segment der Metallschicht elektrisch verbunden sein. Auf diese Weise lässt sich die die Leiterbahn-Segmente aufweisende Metallschicht vor einem Betrachter weitgehend verbergen, was das optische Erscheinungsbild des LED-Flächenstrahlers verbessert. Ein weiterer Vorteil dieser Variante besteht darin, dass die Rückseite der Substratschicht nicht metallisch ausgebildet sein muss, so dass diese anderweitig beschichtet werden kann, beispielsweise mit einer Kunststoffschicht oder ähnlichem, was das Erscheinungsbild des LED-Flächenstrahlers, insbesondere wenn die LED-Leuchtmittel inaktiv sind, also kein Licht emittieren, weiter verbessert. In einer weiterbildenden Ausführungsform kann wenigstens ein Leiterbahn-Segment bezüglich einer Draufsicht auf die Platine jeweils ein erstes und ein zweites im Wesentlichen rechteckartig ausgebildetes Leiterbahn-Untersegment umfassen. Die beiden Leiterbahn-Untersegmente sind elektrisch miteinander verbunden und in einer Längs- und einer Querrichtung der Platine jeweils wenigstens teilweise vernetzt zueinander angeordnet. Somit lässt sich eine besonders große Anzahl von LED-Leuchtmitteln auf dem LED-Flächenstrahler platzieren.

Vorzugsweise beträgt eine Breite des ersten oder/und zweiten rechteckartig ausgebildeten Leiterbahn-Untersegments wenigstens ein Zehnfaches, vorzugsweise wenigstens ein Zwanzigfaches, höchst vorzugsweise wenigstens ein Fünfzigfaches, einer Breite des Aussparungskanals.

In einer weiterbildenden Ausführungsform, in welcher die LED-Leuchtmittel auf sehr einfache Art und Weise auf der Platine befestigt werden können, kann das erste Leiterbahn-Untersegment entlang einer Längsseite einen Vorsprung aufweisen und das zweite Leiterbahn-Untersegment entlang der Längsseite eine zu dem Vorsprung komplementäre Ausnehmung aufweisen oder umgekehrt. Im Bereich von Vorsprung und Ausnehmung ist dann jeweils ein LED-Leuchtmittel angebracht, und zwar derart, dass das einen Vorsprung aufweisende erste Leiterbahn-Untersegment eines ersten Leiterbahn-Segments mittels des LED-Leuchtmittels elektrisch mit einem zweiten Leiterbahn-Untersegment eines zweiten Leiterbahn-Segments elektrisch verbunden wird.

In einer besonders bevorzugten, weiterbildenden Ausführungsform kann daran gedacht sein, dass der LED-Flächenstrahler derart ausgebildet ist, dass eine erste Teilmenge der Mehrzahl von LED-Leuchtmittel elektrisch miteinander verbunden ist und entsprechend eine zweite zu der ersten Teilmenge komplementäre Teilmenge der Mehrzahl von LED-Leuchtmitteln elektrisch miteinander verbunden ist, wobei an dem LED-Flächenstrahler ein erstes und zweites Anschlusselement vorgesehen sind, mittels welchem die erste und zweite Teilmenge jeweils separat mit einer elektrischen Energiequelle verbindbar ist. Auf diese Weise können die der ersten bzw. zweiten Teilmenge zugeordneten LED-Leuchtmittel durch ein geeignetes externes Steuergerät jeweils separat angesteuert und somit ein- bzw. ausgeschaltet werden. Derart lässt sich eine von den LED-Leuchtmitteln erzeugte Abstrahlhelligkeit einstellen.

Selbstverständlich kann in weiterbildenden Varianten auch daran gedacht sein, dass mehrere Teilmengen jeweilige individuelle Anschlusselemente aufweisen, so dass diese ebenfalls durch das externe Steuergerät jeweils separat angesteuert werden können. Bei geeigneter Auslegung kann ein derartiger LED-Flächenstrahler durch Zuschalten bestimmter Teilmengen von LED-Leuchtmitteln bezüglich seiner Abstrahlungshelligkeit verschiedene Helligkeits-Stufen (je nach Anzahl von eingeschalteten Teilmengen von LED-Leuchtmitteln) annehmen.

Des Weiteren kann mittels einer solchen zwei- oder mehrstufigen Anordnung auch eine Farbsteuerung realisiert werden. Hierfür kann beispielsweise daran gedacht sein, dass die erste Teilmenge LED-Leuchtmittel aufweist, welche Licht in einer ersten Farbe (z.B. rot) emittieren, und dass die zweite Teilmenge LED-Leuchtmittel aufweist, welche Licht in einer zweiten Farbe (z.B. blau) emittieren. Auch kann daran gedacht sein, auf diese Weise weißes Licht in der Art eines sog. "Tuneable White", also ein zwischen "kalt-weiß" und "warm-weiß" einstellbares weißes Licht zu erzeugen, so dass dieses an einen Tageslicht-Verlauf angepasst werden kann.

In einer besonders bevorzugten Ausführungsform kann die erste und zweite Teilmenge von den LED-Leuchtmitteln zeilenartig auf der Metallschicht bzw. auf der von der Metallschicht abgewandten Rückseite der Substratschicht angeordnet sein. Diese Anordnung kann vorzugsweise derart realisiert sein, dass sich entlang einer Längsrichtung der Platine unter Ausbildung einer ersten oder zweiten LED-Leuchtmittel-Zeile jeweils LED-Leuchtmittel der ersten bzw. zweiten Teilmenge erstrecken. Entlang einer zur Längsrichtung orthogonal verlaufenden Querrichtung sind dann jeweils erste und zweite LED-Leuchtmittel-Zeilen aneinander angrenzend angeordnet. Auf diese Weise lässt sich auch bei der oben erläuterten zweistufigen Ansteuerung der LED-Leuchtmittel eine besonders homogene Abstrahlcharakteristik des von den LED-Leuchtmitteln abgestrahlten Lichtes erzielen.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert.

Dabei zeigen, jeweils schematisch:
- Fig. 1: ein Ausführungsbeispiel für einen erfindungsgemäßen LED-Flächenstrahler,
- Fig. 2: eine vergrößerte Teilansicht der Figur 1.

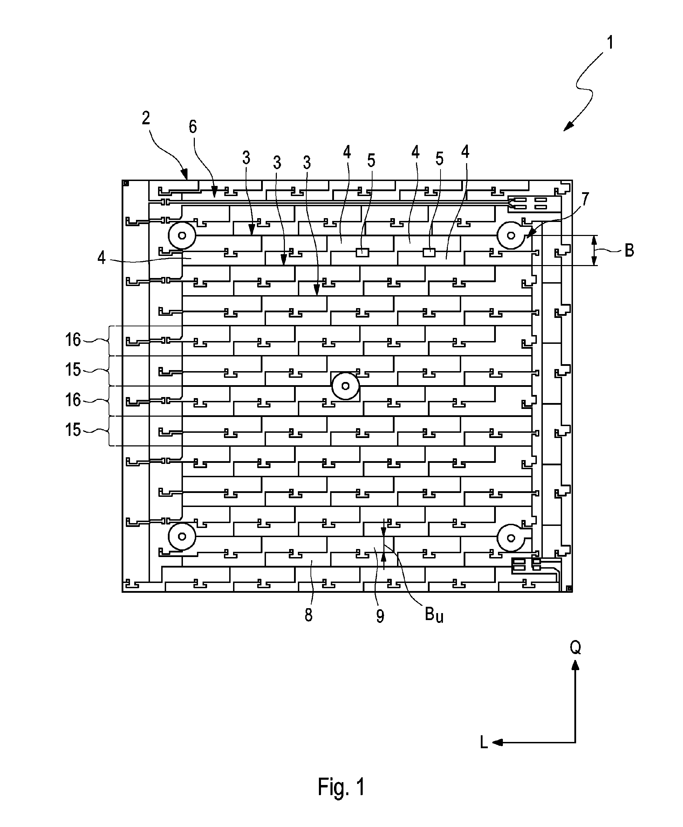

In Figur 1 ist ein erfindungsgemäßer LED-Flächenstrahler in einer Draufsicht dargestellt und mit 1 bezeichnet. Der LED-Flächenstrahler 1 umfasst eine Platine 2, deren elektrisch leitende Oberfläche mittels linienartiger Abtrennungen 3 in eine Mehrzahl von flächig ausgebildeten Leiterbahn-Segmenten 4 unterteilt ist. Die Unterteilung erfolgt dabei derart, dass die Leiterbahn-Segmente 4 aneinander angrenzend und elektrisch voneinander getrennt angeordnet sind. Wenigstens ein erstes Leiterbahn-Segment 4 und ein an das erste Leiterbahn-Segment 4 angrenzendes zweites Leiterbahn-Segment 4 sind mittels eines LED-Leuchtmittels, welches in der Figur 1 nur grobschematisch dargestellt ist und mit dem Bezugszeichen 5 bezeichnet ist, miteinander verbunden. In der Darstellung der Figur 1 sind exemplarisch nur einige wenige LED-Leuchtmittel 5 auf der Platine 2 dargestellt; der erfindungsgemäße LED-Flächenstrahler 1 umfasst jedoch erfindungsgemäß eine Mehrzahl von solchen LED-Leuchtmitteln 5. Das LED-Leuchtmittel 5 kann eine herkömmliche LED mit zwei elektrischen Anschlüssen (Anode und Kathode) sein.

Die Platine 2 des erfindungsgemäßen LED-Flächenstrahlers 1 kann eine in der Draufsicht der Figur 1 nicht sichtbare Substratschicht umfassen. Die Mehrzahl von Leiterbahn-Segmenten 4 wird aus einer auf der Substratschicht angeordneten Metallschicht 6 gebildet. Die Metallschicht 6 kann vorzugsweise eine Kupferschicht oder eine Aluminiumschicht sein. Die linienartige Abtrennung 3 zweier aneinander angrenzender Leiterbahn-Segmente 4 kann jeweils mittels einer Materialaussparung der Metallschicht 6 zwischen zwei aneinander angrenzenden Leiterbahn-Segmenten 4 realisiert sein. Insbesondere kann die Materialaussparung in der Art eines Aussparungskanals mit einer vorbestimmten Aussparungskanal-Breite ausgebildet sein. In einer weiterbildenden Ausführungsform kann zwischen den LED-Leuchtmitteln 5 und der Metallschicht 6 zur verbesserten Wärmeabführung auch eine Wärmeleitschicht angeordnet sein.

Aus der Darstellung der Figur 1 erkennt man, dass wenigstens ein Leiterbahn-Segment 4 in einem Abschnitt 7 rechteckartig ausgebildet sein kann. Vorzugsweise beträgt eine Breite B des abschnittsweise rechteckartig ausgebildeten Leiterbahn-Segments 4 wenigstens ein Zehnfaches, vorzugsweise wenigstens ein Zwanzigfaches, und höchst vorzugsweise wenigstens ein Fünfzigfaches, einer Breite der Aussparungskanal-Breite. Auf diese Weise wird sichergestellt, dass die Leiterbahn-Segmente 5 flächig ausgebildet sind und der größte Teil der Oberfläche der Metallschicht zum Abführen von durch elektrischen Stromfluss erzeugter Abwärme an die Umgebung zur Verfügung steht.

Die Materialaussparung kann vorzugsweise mittels eines Ätzprozesses hergestellt sein. Die Materialaussparung kann in einer alternativen Variante aber auch durch Ausbildung von Einschnitten ausgebildet werden.

In der in der Figur 1 gezeigten Darstellung kann das wenigstens eine LED-Leuchtmittel 5 auf der Metallschicht 6 befestigt sein. In einer alternativen, in der Figur 1 nicht gezeigten Variante, kann jedoch das wenigstens eine LED-Leuchtmittel 5 auch auf einer von der Metallschicht 6 abgewandten Rückseite der Substratschicht der Platine 2 befestigt sein und mittels zweier elektrischer Durchführungen mit dem ersten und zweiten Leiterbahn-Segment 4 der Metallschicht 6 elektrisch verbunden sein.

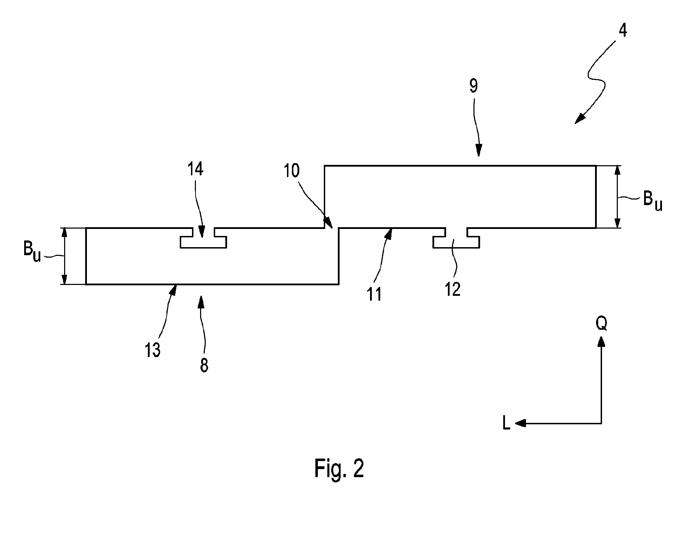

Betrachtet man nun die Darstellung der Figur 2, welche exemplarisch ein Leiterbahn-Segment 4 in einer vergrößerten Darstellung in Draufsicht zeigt, so erkennt man, dass ein solches Leiterbahn-Segment 4 ein erstes und ein zweites, im Wesentlichen jeweils rechteckartig ausgebildetes, Leiterbahn-Untersegment 8, 9 umfassen kann. Die beiden Leiterbahn-Untersegmente 8, 9 können dabei beispielsweise mittels eines Verbindungsabschnitts 10 elektrisch miteinander verbunden sein und in einer Längsrichtung L und einer Querrichtung Q der Platine 2 jeweils wenigstens teilweise versetzt zueinander angeordnet sein. Eine Breite Bᵤ des ersten oder/und zweiten rechteckartig ausgebildeten Leiterbahn-Untersegments 8, 9 kann wenigstens ein Zehnfaches, vorzugsweise wenigstens ein Zwanzigfaches, und höchst vorzugsweise wenigstens ein Fünfzigfaches, der Breite des Aussparungskanals betragen.

Eine besonders effektive Abführung der von den LED-Leuchtmitteln erzeugten Abwärme von der Platine 2 lässt sich erzielen, wenn die Breite B des abschnittsweise rechteckartig ausgebildeten Leiterbahn-Segments 4 zwischen 8mm und 13mm, vorzugsweise zwischen 9mm und 12mm, höchst vorzugsweise zwischen 10mm und 11 mm beträgt.

Um den auf der Platine 2 zur Verfügung stehenden Bauraum besonders effektiv zur Abführung von Abwärme zu nutzen, sollte die vom Aussparungskanal in Anspruch genommene Fläche möglichst gering sein. Dies kann durch eine Ausbildung der Aussparungskanäle mit möglichst kleiner Aussparungskanal-Breite erreicht werden, ohne dass die elektrische Isolierung zwischen benachbarten Leiterbahn-Segmenten gefährdet wird. Eine besonders effektive Abführung der Abwärme von den LED-Leuchtmitteln 5 lässt sich erreichen, wenn die Aussparungskanal-Breite des Aussparungskanals zwischen 0,2mm und 0,5mm vorzugsweise zwischen 0,3mm und 0,4mm, beträgt.

Die Dicke der Platine beträgt zwischen 1,4mm und 1,6mm, vorzugsweise 1,5mm. Entsprechend beträgt die Dicke der Metallschicht 6 zwischen 30 µm und 40µm, vorzugsweise 35µm.

Das zweite Leiterbahn-Untersegment 9 kann entlang einer Längsseite 11 einen Vorsprung 12 aufweisen. Entsprechend kann das erste Leiterbahn-Untersegment 8 entlang seiner Längsseite 13 eine zu dem Vorsprung 12 komplementäre Ausnehmung 14 aufweisen. In einer Variante ist selbstverständlich auch vorstellbar, dass das erste Leiterbahn-Untersegment 8 den Vorsprung und das zweite Leiterbahn-Untersegment 9 die Ausnehmung aufweist. Durch Aneinanderreihung derartig ausgebildeter Leiterbahn-Untersegmente 4 lässt sich die in der Figur 1 gezeigte Platine 2 ausbilden.

In einer Variante des Ausführungsbeispiels kann eine erste Teilmenge der Mehrzahl von LED-Leuchtmitteln 5 elektrisch miteinander verbunden sein und eine zweite, zu der ersten Teilmenge komplementäre Teilmenge der Mehrzahl von LED-Leuchtmitteln 5 elektrisch miteinander verbunden sein, wobei, wie in der Darstellung der Figur 1 gezeigt, an dem Flächenstrahler dann ein erstes und zweites Anschlusselement vorgesehen sein kann, mittels welchem die erste und zweite Teilmenge jeweils separat mit einer elektrischen Energiequelle bzw. einem externen Steuergerät verbindbar sind.

Des Weiteren kann mittels einer solchen zwei- oder mehrstufigen Anordnung auch eine Farbsteuerung realisiert werden. In diesem Fall kann beispielsweise daran gedacht sein, dass die erste Teilmenge LED-Leuchtmittel 5 umfasst, welche Licht in einer ersten Farbe (z.B. rot) emittieren, und dass die zweite Teilmenge LED-Leuchtmittel 5 umfasst, welche Licht in einer zweiten Farbe (z.B. blau) emittieren. Auch kann daran gedacht sein, auf diese Weise weißes Licht in der Art eines sog. "Tuneable White", also ein zwischen "kalt-weiß" und "warm-weiß" einstellbares weißes Licht zu erzeugen, so dass dieses an einen Tageslicht-Verlauf von Sonnenlicht angepasst werden kann.

Die erste und die zweite Teilmenge von LED-Leuchtmitteln 5 kann wie in der Figur 1 gezeigt zeilenartig auf der Metallschicht 6 bzw. der von der Metallschicht 6 abgewandten Rückseite der Substratschicht (in Figur 1 nicht gezeigt) angeordnet sein, und zwar derart, dass sie sich entlang der Längsrichtung L der Platine 2 unter Ausbildung einer ersten oder zweiten LED-Leuchtmittel-Zeile jeweils LED-Leuchtmittel 5 der ersten bzw. zweiten Teilmenge erstrecken. Entlang der zur Längsrichtung L orthogonal verlaufenden Querrichtung Q sind damit abwechselnd jeweils erste und zweite LED-Leuchtmittel-Zeilen 15, 16 aneinander angrenzend angeordnet.

## Patentansprüche

1. LED-Flächenstrahler (1),
- mit einer Mehrzahl von LED-Leuchtmitteln (5),
- mit einer Platine (2), deren elektrisch leitende Oberfläche mittels linienartiger Abtrennungen (3) in eine Mehrzahl von flächig ausgebildeten Leiterbahn-Segmenten (4) unterteilt ist, derart, dass sie aneinander angrenzend und elektrisch voneinander getrennt angeordnet sind,
- wobei wenigstens ein erstes Leiterbahn-Segment (4) und ein an das erste Leiterbahn-Segment (4) angrenzendes zweites Leiterbahn-Segment (4) mittels eines LED-Leuchtmittels (5) elektrisch miteinander verbunden sind.

2. LED-Flächenstrahler (1) nach Anspruch 1,
**dadurch gekennzeichnet, dass**
- die Platine (2) eine Substratschicht umfasst,
- die Mehrzahl von Leiterbahn-Segmenten (4) aus einer auf der Substratschicht angeordneten Metallschicht (6) gebildet ist,
- die linienartige Abtrennung (3) zweier aneinander angrenzender Leiterbahn-Segmente (4) jeweils mittels einer Materialaussparung der Metallschicht (6) zwischen diesen beiden Leiterbahn-Segmenten (4) realisiert ist.

3. LED-Flächenstrahler (1) nach Anspruch 2,
**dadurch gekennzeichnet, dass**
die Materialaussparung zwischen zwei benachbarten Leiterbahn-Segmenten (4) in der Art eines Aussparungskanals mit einer vorbestimmten Aussparungskanal-Breite ausgebildet ist.

4. LED-Flächenstrahler (1) nach Anspruch 3,
**dadurch gekennzeichnet, dass**
- wenigstens ein Leiterbahn-Segment (4) wenigstens abschnittsweise rechteckartig ausgebildet ist,
- eine Breite (B) des abschnittsweise rechteckartig ausgebildeten Leiterbahn-Segments (4) wenigstens ein Zehnfaches, vorzugsweise wenigstens ein Zwanzigfaches, höchst vorzugsweise wenigstens ein Fünfzigfaches, einer Breite der Aussparungskanal-Breite beträgt.

5. LED-Flächenstrahler (1) nach Anspruch 4,
**dadurch gekennzeichnet, dass**
die Breite (B) des abschnittsweise rechteckartig ausgebildeten Leiterbahn-Segments (4) zwischen 8mm und 13mm, vorzugsweise zwischen 9mm und 12mm, höchst vorzugsweise zwischen 10mm und 11 mm, beträgt.

6. LED-Flächenstrahler (1) nach Anspruch 4 oder 5,
**dadurch gekennzeichnet, dass**
die Aussparungskanal-Breite zwischen 0,2mm und 0,5mm vorzugsweise zwischen 0,3mm und 0,4mm, beträgt.

7. LED-Flächenstrahler (1) nach einem der Ansprüche 4 bis 6,
**dadurch gekennzeichnet, dass**
- eine Dicke der Platine (2) zwischen 1,4mm und 1,6mm, vorzugsweise 1,5mm, beträgt, und/oder dass
- eine Dicke der Metallschicht (6) zwischen 30µm und 40µm, vorzugsweise 35µm, beträgt.

8. LED-Flächenstrahler (1) nach einem der Ansprüche 2 bis 7,
**dadurch gekennzeichnet, dass**
die Metallschicht (6) eine Kupferschicht ist.

9. LED-Flächenstrahler (1) nach einem der vorhergehenden Ansprüche,
**dadurch gekennzeichnet dass**
das wenigstens eine LED-Leuchtmittel (5) auf der Metallschicht (6) befestigt ist.

10. LED-Flächenstrahler (1) nach einem der Ansprüche 1 bis 8,
**dadurch gekennzeichnet dass**
das wenigstens eine LED-Leuchtmittel (5) auf einer von der Metallschicht (6) abgewandten Rückseite der Substratschicht befestigt ist und mittels zweier elektrischer Durchführungen mit dem ersten und zweiten Leiterbahn-Segment (4) der Metallschicht elektrisch verbunden ist.

11. LED-Flächenstrahler (1) nach einem der Ansprüche 2 bis 10,
**dadurch gekennzeichnet, dass**
- wenigstens ein Leiterbahn-Segment (4) bezüglich einer Draufsicht auf die Platine (2) jeweils ein erstes und ein zweites im Wesentlichen rechteckartig ausgebildetes Leiterbahn-Untersegment (8, 9) umfasst,
- die beiden Leiterbahn-Untersegmente (8, 9) elektrisch miteinander verbunden sind und in einer Längs- und einer Querrichtung (L, Q) der Platine (2) jeweils wenigstens teilweise versetzt zueinander angeordnet sind.

12. LED-Flächenstrahler (1) nach Anspruch 11,
**dadurch gekennzeichnet, dass**
- eine Breite (Bᵤ) des ersten oder/und zweiten rechteckartig ausgebildeten Leiterbahn-Untersegments wenigstens ein Zehnfaches, vorzugsweise wenigstens ein Zwanzigfaches, höchst vorzugsweise wenigstens ein Fünfzigfaches, einer Breite des Aussparungskanals beträgt.

13. LED-Flächenstrahler (1) nach Anspruch 11 oder 12,
**dadurch gekennzeichnet, dass**
- das erste Leiterbahn-Untersegment entlang einer Längsseite einen Vorsprung aufweist, und dass
- das zweite Leiterbahn-Untersegment entlang der Längsseite eine zu dem Vorsprung komplementäre Ausnehmung aufweist oder umgekehrt.

14. LED-Flächenstrahler (1) nach einem der vorhergehenden Ansprüche,
**dadurch gekennzeichnet, dass**
der LED-Flächenstrahler derart ausgebildet ist, dass
- eine erste Teilmenge der Mehrzahl von LED-Leuchtmittel (5) elektrisch miteinander verbunden ist und eine zweite zu der ersten Teilmenge komplementäre Teilmenge der Mehrzahl von LED-Leuchtmittel (5) elektrisch miteinander verbunden ist,
- an dem LED-Flächenstrahler (1) ein erstes und zweites Anschlusselement vorgesehen sind, mittels welchen die erste und zweite Teilmenge jeweils separat mit einer elektrischen Energiequelle verbindbar sind.

15. LED-Flächenstrahler (1) nach Anspruch 14,
**dadurch gekennzeichnet, dass**
- die erste und zweite Teilmenge von LED-Leuchtmitteln (5) zeilenartig auf der Metallschicht (6) bzw. der von der Metallschicht (6) abgewandten Rückseite der Substratschicht angeordnet sind, derart, dass sich entlang der Längsrichtung (L) der Platine (2) unter Ausbildung einer ersten oder zweiten LED-Leuchtmittel-Zeile (15, 16) jeweils LED-Leuchtmittel (5) der ersten bzw. zweiten Teilmenge erstrecken,
- entlang der zur Längsrichtung (L) orthogonal verlaufenden Querrichtung (Q) abwechselnd jeweils erste und zweite LED-Leuchtmittel-Zeilen (15, 16) aneinander angrenzend angeordnet sind.
